# EUROPÄISCHE PATENTSCHRIFT

(11) **EP 1 771 877 B1**
(45) Veröffentlichungstag und Bekanntmachung des Hinweises auf die Patenterteilung: **05.03.2008**
(21) Anmeldenummer: 06700043.0
(22) Anmeldetag: 05.01.2006
(51) Int. Cl.: H01L 21/60

(54) **WAFERTISCH ZUM BEREITSTELLEN VON ELEKTRISCHEN BAUELEMENTEN UND VORRICHTUNG ZUM BESTÜCKEN VON SUBSTRATEN MIT DEN BAUELEMENTEN**
WAFER TABLE FOR PREPARING ELECTRICAL COMPONENTS AND DEVICE FOR EQUIPPING SUBSTRATES WITH THE COMPONENTS
PORTE-PLAQUETTE SERVANT A PREPARER DES COMPOSANTS ELECTRIQUES, ET DISPOSITIF POUR EQUIPER DES SUBSTRATS AU MOYEN DESDITS COMPOSANTS

(30) Priorität: 25.01.2005 DE 102005003454
(43) Veröffentlichungstag der Anmeldung: 11.04.2007
(73) Patentinhaber: SIEMENS AKTIENGESELLSCHAFT, 80333 München (DE)
(72) Erfinder: FRINDT, Matthias, 83646 Bad Tölz (DE); MEHDIANPOUR, Mohammad, 81829 München (DE); STANZL, Harald, 81476 München (DE)
(86) Internationale Anmeldenummer: PCT/EP2006/050058
(87) Internationale Veröffentlichungsnummer: WO 2006/079577

(56) Entgegenhaltungen:
- EP-A- 0 971 390
- EP-A1- 1 120 827
- JP-A- 2 056 946
- JP-A- 7 221 164
- JP-A- 60 207 349
- JP-A- 2004 103 923
- US-A- 5 839 187

## Beschreibung

Die Erfindung bezieht sich auf einen Wafertisch zum Bereitstellen von elektrischen Bauelementen eines Wafers, der auf einen Drehteller des Wafertischs auflegbar ist, wobei der Drehteller parallel zur Waferebene in diskreten Schritten feinstufig derart bewegbar ist, dass die Bauelemente an eine ortfeste Abholposition gelangen, der zumindest eine ortsfeste Hilfseinrichtung zugeordnet ist.

Ein derartiger Wafertisch ist z. B. durch die EP0971390 A bekannt geworden. Danach ist ein Bestückkopf zwischen zwei fest vorgegebenen Orten parallel zu einem Substrat linear verfahrbar, das auf einem getakteten Bandtransport geführt ist. Neben dem Bandtransport befindet sich der Wafertisch mit einem x-y-verschiebbaren Kreuzschlitten, auf dem Bauelemente in einem zum Substrat parallelen Wafer bereitgestellt werden. Dabei kann jeweils eines der Bauelemente an dem ortsfesten Abholplatz vom Bestückkopf erfasst, über das seitlich verschiebbare Substrat verfahren und auf dieses aufgesetzt werden. Da der Wafertisch nur einen begrenzten x-y-Verschiebebbereich aufweist, ist es nicht möglich alle Bauelemente des Wafers an den Abholort des Bestückkopfes zu bringen. Der Wafer liegt auf einem Drehteller des Kreuzschlittens auf und kann um 90° oder 180° verdreht werden, um auch die restlichen Bauelemente abzuholen.

Der Erfindung liegt die Aufgabe zugrunde, einen einfacheren Wafertisch von verringerter Baubreite zu schaffen.

Diese Aufgabe wird durch die Erfindung gemäß Anspruch 1 gelöst. Bei dem erfindungsgemäßen Wafertisch tritt an die Stelle einer der x-y-Linearachsen des Kreuzschlittens der feinstufige Drehantrieb mit einem einfachen Drehlager und Drehantrieb anstelle einer Linearführung und eines Linearantriebs. Es verbleibt lediglich eine stationäre Linearführung für den Schlitten. Eine solche einfache Führung lässt eine höhere Positioniergenauigkeit als eine komplexere Kreuzführung mit sich überlagernden Bewegungen zu. Die Drehbewegung bedarf keines zusätzlichen Bewegungsraums. Der Drehteller wird lediglich linear bewegt. Der Wafertisch kann daher in geringerer Baubreite ausgeführt werden, was seine Einsatzmöglichkeit z.B. bei der Bestückung von Leiterplatten erhöht. Durch die Verdrehung des Wafers verändert sich zwar die Winkellage des jeweiligen Bauelements. Dies kann dadurch korrigiert werden, dass ein nachfolgendes Greifwerkzeug z.B. eines Bestückkopfes eine entsprechende Gegendrehung ausführt.

Vorteilhafte Weiterbildungen der Erfindung sind in den Ansprüchen 2 bis 6 gekennzeichnet.

Durch die Weiterbildung nach Anspruch 2 wird die Winkellage der Abrücknadeln der des jeweils abzuholenden Bauelements angepasst.

Durch die Flipeinrichtung nach Anspruch 3 kann das z.B. als Flip-Chip ausgebildete Bauelement in eine Übergabestellung bewegt werden, in der es in einer montagegerechten Orientierung von einem Bestückkopf übernommen werden kann.

Bei der Bestückvorrichtung nach Anspruch 4 verringert sich die Stellbreite des Wafertischs erheblich.

Durch die Kamera nach Anspruch 5 kann die genaue Lage, insbesondere Winkellage des Bauelements am Greifer des Bestückkopfes ermittelt und entsprechend korrigiert werden.

Die Weiterbildung nach Anspruch 6 wird durch die schmale Bauweise des Wafertischs ermöglicht, so dass zusätzlichen Bauelementen aus anderen Vorratsspeichern, z.B. aus Bauelementegurten mittels Gurtförderern bereitgestellt werden können.

Im folgenden wird die Erfindung anhand eines in der Zeichnung dargestellten Ausführungsbeispieles näher erläutert. Es zeigen:
- Figur 1: eine Seitenansicht einer Bestückvorrichtung mit einem Wafertisch gemäß der Erfindung,
- Figur 2: einen Schnitt entlang der Linie II-II in Figur 1

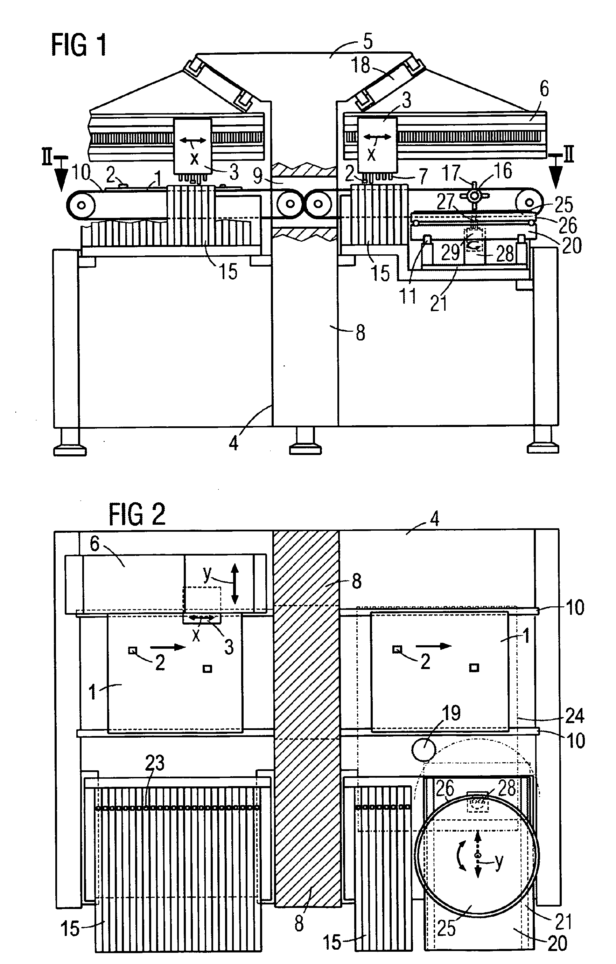

Die Figuren 1 und 2 zeigen eine Vorrichtung zum Bestücken von flachen Substraten 1 mit elektrischen Bauelementen 2 mittels eines in einer Arbeitsebene parallel zum Substrat 1 verfahrbaren Bestückkopfes 3. Ein Chassis 4 der Vorrichtung weist einen stationären Träger 5 auf, an dem ein Positionierarm 6 in einer zweiten Koordinatenrichtung Y verschiebbar geführt und mittels eines Linearmotors angetrieben ist. Der Bestückkopf 3 ist am länglichen Positionierarm 6 in einer zu zweiten Koordinatenrichtung y senkrechten ersten Koordinatenrichtung x verschiebbar geführt. Der Träger 5 ist mit einer nach unten weisenden, sich in der Längsrichtung erstreckenden starren Tragwand 8 über seine gesamte Länge fest verbunden

Die Tragwand 8 ist in ihrem mittleren Bereich mit einem Durchbruch 9 versehen, durch den eine Transportstrecke 10 für die Substrate 1 senkrecht hindurch geführt ist. Die gesamte Vorrichtung ist zu beiden Seiten der Tragwand 8 spiegelsymmetrisch aufgebaut mit dem nach beiden Seiten auskragenden Träger 5, den Positionierarmen 6 und Bestückköpfen 3. Die Substrate 1 können dementsprechend auf der Transportstrecke 10 an Bestückplätzen zu beiden Seiten der Tragwand 8 wie dargestellt temporär fixiert werden.

Neben der Transportstrecke sind vor den Bestückplätzen Stellplätze für einen Wafertisch 21 sowie für schmale, nebeneinanderliegende Bauelementezuführungen 15 angeordnet. Diese weisen eine Reihe von Abholplätze 23 auf, an denen die z.B. aus Spulen zugeführten Bauelemente 2 durch den Bestückkopf 3 entnommen werden können, der dann diese Bauelemente 2 zu ihren Montageplätzen auf dem Substrat 1 transportiert.

Ein durch die strichpunktierten Linien markierter maximaler Zugriffsbereich 24 des Bestückkopfes 3 überdeckt den Bestückbereich des Substrats 1 und den Abholbereich der Bauelemente 2 mit den Abholplätzen 23. Wafertisch 21 ist unmittelbar neben einigen der Bauelementezuführungen 15 angeordnet und mit einem Drehteller 26 versehen, auf dem ein zum Substrat paralleler Wafer 25 aufliegt. Der Drehteller 26 ist mit einer zum Wafer 25 senkrechten Drehachse versehen und mit einem nicht dargestellten Drehantrieb gekoppelt, der eine Verdrehung des Drehtellers 26 in kleinen Winkelschritten ermöglicht. Der Drehteller 26 ist auf einem in einer stationären Linearführung 11 verschiebbaren Schlitten 20 gelagert, der durch einen nicht dargestellten Linearantrieb feinstufig verschiebbar ist.

Durch Kombination der Linear- und Winkelkoordinaten des Schlittens 20 und des Drehtellers 26 ist es möglich, jedes der Bauelemente 2 an eine ortsfeste Abholposition zu bewegen, die durch die Lage eines ortsfesten Ejektors 28 definiert ist, der unterhalb des Wafers 25 angeordnet ist. Diese ist mit nach oben weisenden anhebbaren Abdrücknadeln 27 versehen, die die Bauelemente 2 von einer Trägerfolie des Wafers abheben. Die Abdrücknadeln 27 sind an einem feinstufig winkelverstellbaren Rotor 29 des Ejektors 28 gelagert und können somit in eine an das Bauelement 2 angepasste Winkellage verdreht werden.

Über dem Ejektor 28 befindet am Wafertisch 21 eine revolverartige Flipeinrichtung 16 mit Sauggreifern 17 für die angehobenen Bauelemente 2. Die Sauggreifer 17 werden durch schrittweises Verdrehen um eine waagerechte Achse mit dem angesaugten Bauelementen 2 nach oben gedreht und gewendet. In dieser Übergabestellung werden die Bauelemente 2 von den Greifern 7 des Bestückkopfes 3 erfasst. Dieser verfährt über eine im Chassis gehaltene Kamera 19, die die genaue Lage der Bauelemente 2 vermisst. Die Greifer 7 sind mittels eines zweiter Drehantriebe um ihre Längsachse verdrehbar und können die angesaugten Bauelemente 2 in die vorgesehene Bestücklage verdrehen.

Die waagerechte Verschieberichtung des Schlittens 20 ist senkrecht zur Transportstrecke 10 der Substrate 1 orientiert. Dadurch benötigt der Wafertisch 21 eine geringe Einbaubreite, wodurch Stellplätze für weitere der Zuführeinrichtungen 15 gewonnen werden.

### Bezugszeichen

- x, y: Koordinatenrichtung
- 1: Substrat
- 2: Bauelement
- 3: Bestückkopf
- 4: Chassis
- 5: Träger
- 6: Positionierarm
- 7: Greifer
- 8: Tragwand
- 9: Durchbruch
- 10: Transportstrecke
- 15: Bauelementezuführung
- 16: Flipeinrichtung
- 17: Sauggreifer
- 18: Linearmotor
- 19: Kamera
- 20: Schlitten
- 21: Wafertisch
- 23: Abholplatz
- 24: Zugriffsbereich
- 25: Wafer
- 26: Drehteller
- 27: Abdrücknadel
- 28: Ejektor
- 29: Rotor

## Patentansprüche

1. Wafertisch (21) zum Bereitstellen von elektrischen Bauelementen (2) eines Wafers (25), der auf einen Drehteller (26) des Wafertischs (21) auflegbar ist,
wobei der Drehteller (26) parallel zur Waferebene in diskreten Schritten feinstufig derart bewegbar ist, dass
die Bauelemente (2) an eine ortfeste Abholposition gelangen, der zumindest eine ortsfeste Hilfseinrichtung zugeordnet ist,
**dadurch gekennzeichnet, dass** der Drehteller (26) mittels eines feinstufig betätigbaren ersten Drehantriebs verdrehbar ist,
dass der Drehteller (26) auf einem in einer stationären Linearführung (11) verschiebbaren Schlitten (20) gelagert ist, der mittels eines feinstufig betätigbaren Linearantriebs parallel zum Wafer (25) verschiebbar ist und
dass der erste Drehantrieb und der Linearantrieb derart positionierbar sind, dass jedes der Bauelemente (2) an die Abholposition gelangt.

2. Wafertisch nach Anspruch 1,
**dadurch gekennzeichnet, dass** die Hilfseinrichtung als Ejektor (28) zum Ablösen der Bauelemente (2) von einer Trägerfolie des Wafers (25) ausgebildet ist und einen Rotor (29) mit einer senkrecht zur Waferebene stehenden Drehachse aufweist,
dass der Rotor (29) zumindest zwei zueinander beabstandete Abdrücknadeln (27) für die Bauelemente (2) aufweist und
dass der Rotor (29) entsprechend der Winkelstellung des Drehtellers (26) feinstufig verdrehbar ist.

3. Wafertisch nach Anspruch 1 oder 2,
**dadurch gekennzeichnet, dass** an der Abholposition eine weitere Hilfseinrichtung in Form einer ortsfesten Flipeinrichtung (16) zum Aufnehmen und Wenden der Bauelemente (2) vorgesehen ist.

4. Vorrichtung zum Bestücken von Substraten (1) mit den auf dem Wafertisch nach Anspruch 1, 2 oder 3 bereitstellbaren elektrischen Bauelementen (2) mittels eines parallel zum Substrat (1) verschiebbaren Bestückkopfes (3) mit zumindest einem Greifer (7) zum Handhaben der Bauelemente (2),
wobei das Substrat (1) in einer ersten Koordinatenrichtung X durch die Vorrichtung transportierbar ist,
**dadurch gekennzeichnet, dass** der Greifer (7) mit einem feinstufig betätigbaren zweiten Drehantrieb gekoppelt ist und
dass der Schlitten (20) in einer zur ersten Koordinatenrichtung (x) annähernd senkrechten zweiten Koordinatenrichtung (y) verschiebbar ist.

5. Vorrichtung nach Anspruch 4,
**dadurch gekennzeichnet, dass** die Vorrichtung eine Kamera (19) zum Ermitteln der Lage des Bauelements (2) an dem Greifer (7) aufweist.

6. Vorrichtung nach Anspruch 4 oder 5,
**dadurch gekennzeichnet, dass** neben dem Wafertisch (21) Stellplätze für andersartige Zuführeinrichtungen (15) im Zugriffsbereich (24) des Bestückkopfes (3) vorgesehen sind.

## Claims

1. Wafer table (21) for preparation of electrical components (2) for a wafer (25) which can be placed on a rotating plate (26) of the wafer table (21),
wherein the rotating plate (26) can be moved in fine discrete steps parallel to the wafer plane, such that the components (2) are moved to a fixed pick-up position which has at least one fixed associated auxiliary device,
**characterized**
**in that** the rotating plate (26) can be rotated by means of a first rotary drive which can be operated in fine steps,
**in that** the rotating plate (26) is mounted on a carriage (20) which can be moved in a stationary linear guide (11) and can be moved parallel to the wafer (25) by means of a linear drive which can be operated in fine steps, and
**in that** the first rotary drive and the linear drive can be positioned such that each of the components (2) is moved to the pick-up position.

2. Wafer table according to Claim 1,
**characterized**
**in that** the auxiliary device is in the form of an ejector (28) for detaching the components (2) from a mount film of the wafer (25) and has a rotor (29) with a rotation axis at right angles to the wafer plane,
**in that** the rotor (29) has at least two pushing-down needles (27), which are at a distance from one another, for the components (2), and
**in that** the rotor (29) can be rotated in fine steps corresponding to the angular position of the rotating plate (26).

3. Wafer table according to Claim 1 or 2,
**characterized**
**in that** a further auxiliary device is provided at the pick-up position, in the form of a fixed flipping device (16) for picking up and turning the components (2).

4. Apparatus for placing electrical components (2), which can be prepared on the wafer table according to Claim 1, 2 or 3, on substrates (1) by means of a placement head (3) which can be moved parallel to the substrate (1) and has at least one gripper (7) for handling the components (2),
wherein the substrate (1) can be transported through the apparatus in a first coordinate direction (x),
**characterized**
**in that** the gripper (7) is coupled to a second rotary drive which can be operated in fine steps, and
**in that** the carriage (20) can be moved in a second coordinate direction (y), approximately at right angles to the first coordinate direction (x).

5. Apparatus according to Claim 4,
**characterized**
**in that** the apparatus has a camera (19) for determining the orientation of the component (2) on the gripper (7).

6. Apparatus according to Claim 4 or 5,
**characterized**
**in that** locations are provided alongside the wafer table (21) for different types of feed devices (15) in the access area (24) of the placement head (3).

## Revendications

1. Porte-plaquette (21) servant à préparer des composants (2) électriques d'une plaquette (25) qui peut être placée sur un plateau tournant (26) du porte-plaquette (21),
le plateau tournant (26) étant mobile par réglage fin parallèlement au plan de plaquette avec des pas discrets de sorte que les composants (2) arrivent dans une position de prélèvement fixe à laquelle est affecté au moins un dispositif auxiliaire fixe, **caractérisé en ce que**
le plateau tournant (26) peut tourner au moyen d'un premier entraînement tournant actionnable par réglage fin,
le plateau tournant (26) repose sur un chariot (20), pouvant être déplacé dans un guidage linéaire (11) stationnaire, qui peut être déplacé parallèlement à la plaquette (25) au moyen d'un entraînement linéaire actionnable par réglage fin et
le premier entraînement tournant et l'entraînement linéaire sont positionnables de sorte que chacun des composants (2) arrive à la position de prélèvement.

2. Porte-plaquette selon la revendication 1,
**caractérisé en ce que** le dispositif auxiliaire est constitué en tant qu'éjecteur (28) pour détacher les composants (2) d'un feuillet porteur de la plaquette (25), et présente un rotor (29) ayant un axe de rotation perpendiculaire au plan de plaquette,
**en ce que** le rotor (29) présente au moins deux aiguilles de pression (27), distantes l'une de l'autre, pour les composants (2) et
**en ce que** le rotor (29) peut tourner par réglage fin en fonction de la position angulaire du plateau tournant (26).

3. Porte-plaquette selon la revendication 1 ou 2,
**caractérisé en ce que**, sur la position de prélèvement, il est prévu un autre dispositif auxiliaire sous la forme d'un dispositif de retournement (16) fixe pour soulever et tourner les composants (2).

4. Dispositif pour équiper des substrats (1) avec les composants (2) électriques, pouvant être préparés sur le porte-plaquette selon la revendication 1, 2 ou 3, au moyen d'une tête d'équipement (3) déplaçable parallèlement au substrat (1) ayant au moins un grappin (7) pour manipuler les composants (2),
le substrat (1) étant transportable dans une première direction de coordonnées X par le dispositif,
**caractérisé en ce que** le grappin (7) est couplé à un deuxième entraînement tournant actionnable par réglage fin et
**en ce que** le chariot (20) est déplaçable dans une deuxième direction de coordonnées (y) à peu près perpendiculaire à la première direction de coordonnées (x).

5. Dispositif selon la revendication 4,
**caractérisé en ce que** le dispositif a une caméra (19) pour déterminer la position du composant (2) sur le grappin (7).

6. Dispositif selon la revendication 4 ou 5,
**caractérisé en ce que**, outre le porte-plaquette (21), il est prévu des emplacements de réglage pour des équipements d'acheminement (15) d'un autre type dans la zone d'accès (24) de la tête d'équipement (3).
